# EUROPEAN PATENT APPLICATION

(11) **EP 4 770 351 A1**
(43) Date of publication of application: **01.07.2026**
(21) Application number: 25191379.4
(22) Date of filing: 23.07.2025
(51) Int. Cl.: H10H 20/01, H10H 20/816, H10H 20/824, H10H 20/831, H10H 20/832, H10H 20/833

(54) **LIGHT EMITTING DIODE AND MANUFACTURING METHOD THEREOF**

(30) Priority: 24.12.2024 TW 113150514
(71) Applicant: Taiwan-Asia Semiconductor Corporation, Hsinchu City 30078 (TW)
(72) Inventor: Lee, Yueh-Lin, 30078 Hsinchu City (TW)
(74) Representative: Michalski Hüttermann & Partner mbB

(57) **Abstract**

A light-emitting diode and a manufacturing method thereof are provided. The light-emitting diode comprises a permanent substrate, an epitaxial composite layer, an upper electrode, and an upper ohmic contact layer. The epitaxial composite layer has a light-emitting layer with a light-emitting wavelength band of 1100 to 1700 nanometers, which is disposed on the permanent substrate. The upper electrode is disposed on the epitaxial composite layer and is electrically connected to the epitaxial composite layer. The upper ohmic contact layer is sandwiched between the upper electrode and the epitaxial composite layer. An ohmic contact is formed between the upper ohmic contact layer and the upper electrode, and both have the same cross-sectional horizontal width.

## Description

### BACKGROUND OF THE INVENTION

### Field of the Invention

This invention relates to a light-emitting diode and a manufacturing method thereof, and in particular to a high-power light-emitting diode and a manufacturing method thereof.

### Descriptions of the Related Art

A Light-Emitting Diode (LED) offers advantages such as high brightness, compact size, low power consumption, and long lifespan, making it widely used in lighting or display products. In conventional short wavelength infrared (SWIR) LEDs, to form good N-type and P-type ohmic contacts with positive and negative electrodes, a highly doped epitaxial layer is disposed on both the front and back surfaces of the epitaxial structure. These highly doped epitaxial layers are made of narrow bandgap materials, which cause a certain degree of light absorption, thereby reducing the emission power of the LED. To overcome the above issues, there is an urgent need in the industry for an innovative LED structure and manufacturing method to enhance emission power.

### SUMMARY OF THE INVENTION

The main objective of this invention is to provide a high-brightness light-emitting diode and a manufacturing method thereof. By removing portions of the highly doped epitaxial layers on the front and back surfaces, except for the areas required for N-type and P-type ohmic contacts, this innovative structure reduces the area where light is absorbed, thereby achieving enhanced brightness.

To achieve the above objective, this invention provides a light-emitting diode comprising a permanent substrate, an epitaxial composite layer, an upper electrode, and an upper ohmic contact layer. The epitaxial composite layer includes a light-emitting layer with a light-emitting wavelength band of 1100 to 1700 nanometers (nm) and is disposed on the permanent substrate. The upper electrode is disposed on the epitaxial composite layer and is electrically connected to the epitaxial composite layer. The upper ohmic contact layer is sandwiched between the upper electrode and the epitaxial composite layer, forming an ohmic contact with the upper electrode, and both have the same cross-sectional horizontal width.

In one embodiment of the light-emitting diode of this invention, the upper ohmic contact layer is an indium gallium arsenide (InGaAs) layer.

In one embodiment of the light-emitting diode of this invention, the light-emitting diode further comprises a reflective metal layer disposed on the permanent substrate.

In one embodiment of the light-emitting diode of this invention, the light-emitting diode further comprises a transparent conductive layer sandwiched between the reflective metal layer and the epitaxial composite layer, having a plurality of conductive plugs disposed in the transparent conductive layer. Each conductive plug includes a highly doped compound semiconductor layer that is lattice-matched and electrically connected to the epitaxial composite layer, forming an ohmic contact with the transparent conductive layer.

In one embodiment of the light-emitting diode of this invention, the highly doped compound semiconductor layer is a zinc-doped indium gallium arsenide phosphide (Zn-doped InGaAsP) layer.

In one embodiment of the light-emitting diode of this invention, each conductive plug further comprises a metal stack sandwiched between the transparent conductive layer and the highly doped compound semiconductor layer, wherein the metal stack is a titanium (Ti)/platinum (Pt)/gold (Au) stack.

In one embodiment of the light-emitting diode of this invention, the material of the reflective metal layer is selected from the group consisting of silver (Ag), titanium (Ti), platinum (Pt), gold (Au), indium (In), and combinations thereof.

In one embodiment of the light-emitting diode of this invention, the upper electrode and the conductive plugs do not overlap in vertical position.

To achieve the above objective, this invention provides a light-emitting diode comprising a permanent substrate, a reflective metal layer, an epitaxial composite layer, and a transparent conductive layer. The reflective metal layer is disposed on the permanent substrate. The epitaxial composite layer includes a light-emitting layer with a light-emitting wavelength band of 1100 to 1700 nanometers (nm) and is disposed on the reflective metal layer. The transparent conductive layer is sandwiched between the reflective metal layer and the epitaxial composite layer, having a plurality of conductive plugs disposed in the transparent conductive layer. Each conductive plug includes a highly doped compound semiconductor layer that is lattice-matched and electrically connected to the epitaxial composite layer, forming an ohmic contact with the transparent conductive layer.

In another embodiment of the light-emitting diode of this invention, the highly doped compound semiconductor layer is a zinc-doped indium gallium arsenide phosphide (Zn-doped InGaAsP) layer.

In another embodiment of the light-emitting diode of this invention, each conductive plug further comprises a metal stack sandwiched between the transparent conductive layer and the highly doped compound semiconductor layer, wherein the metal stack is a titanium (Ti)/platinum (Pt)/gold (Au) stack.

In another embodiment of the light-emitting diode of this invention, the material of the reflective metal layer is selected from the group consisting of silver (Ag), titanium (Ti), platinum (Pt), gold (Au), indium (In), and combinations thereof.

To achieve the above objective, this invention provides a manufacturing method of a light-emitting diode, comprising the following steps: first, providing an epitaxial composite layer having a light-emitting layer with a light-emitting wavelength band of 1100 to 1700 nanometers (nm); next, providing an upper ohmic contact layer disposed on the epitaxial composite layer; and finally, providing an upper electrode disposed on the upper ohmic contact layer and electrically connected to the epitaxial composite layer. The upper ohmic contact layer forms an ohmic contact with the upper electrode, and both have the same cross-sectional horizontal width.

In one embodiment of the manufacturing method of the light-emitting diode of this invention, the step of providing an upper ohmic contact layer is a step of providing an indium gallium arsenide (InGaAs) layer.

In one embodiment of the manufacturing method of the light-emitting diode of this invention, the method further comprises providing a reflective metal layer disposed on a permanent substrate.

In one embodiment of the manufacturing method of the light-emitting diode of this invention, the method further comprises providing a transparent conductive layer sandwiched between the reflective metal layer and the epitaxial composite layer, the transparent conductive layer having a plurality of conductive plugs disposed in the transparent conductive layer. Each conductive plug includes a highly doped compound semiconductor layer that is lattice-matched and electrically connected to the epitaxial composite layer, forming an ohmic contact with the transparent conductive layer.

In one embodiment of the manufacturing method of the light-emitting diode of this invention, the highly doped compound semiconductor layer is a zinc-doped indium gallium arsenide phosphide (Zn-doped InGaAsP) layer.

In one embodiment of the manufacturing method of the light-emitting diode of this invention, each conductive plug further comprises a metal stack sandwiched between the transparent conductive layer and the highly doped compound semiconductor layer, wherein the metal stack is a titanium (Ti)/platinum (Pt)/gold (Au) stack.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1A to FIG. 1G are schematic diagrams illustrating the manufacturing of a light-emitting diode in one embodiment of this invention;
FIG. 2 is a schematic diagram of a light-emitting diode in one embodiment of this invention;
FIG. 3 is a schematic diagram of a light-emitting diode in one embodiment of this invention;
FIG. 4 is a schematic diagram of a light-emitting diode in one embodiment of this invention;
FIG. 5 is a schematic diagram of a light-emitting diode in one embodiment of this invention;
FIG. 6 is a schematic diagram of a light-emitting diode in one embodiment of this invention;
FIG. 7 is a schematic diagram of a light-emitting diode in one embodiment of this invention; and
FIG. 8 is a schematic flowchart of the manufacturing process steps of a light-emitting diode in one embodiment of this invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

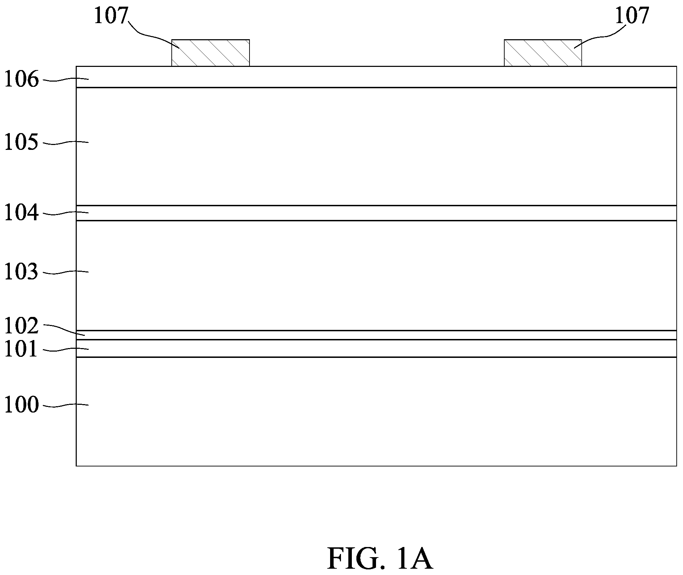

This invention discloses a light-emitting diode and a manufacturing method thereof. Please refer to FIG. 1A, which illustrates the epitaxial growth of a buffer layer 101 and an upper ohmic contact layer 102 on an epitaxial growth substrate 100 using techniques such as Metal Organic Chemical Vapor Deposition (MOCVD) or Molecular Beam Epitaxy (MBE). Specifically, the buffer layer 101 is an N-type indium phosphide (InP) epitaxial layer used to adjust lattice matching between the epitaxial growth substrate and the subsequent epitaxial composite layer, reducing stress caused by lattice mismatch during the subsequent epitaxial process, thereby improving the film quality of subsequent epitaxial layers. Next, the upper ohmic contact layer 102 is specifically an N-type indium gallium arsenide (InGaAs) epitaxial layer, with a lattice constant between that of indium phosphide (InP) and the multiple quantum well structure. Thus, the N-type indium gallium arsenide epitaxial layer also serves as a buffer layer, further facilitating lattice matching for subsequent epitaxial layers. Additionally, the N-type indium gallium arsenide epitaxial layer optimizes carrier injection efficiency, allowing adjustment of its bandgap based on the ratio of gallium and indium to control electron and hole transport, ensuring more carriers are effectively injected into the light-emitting layer, enhancing emission efficiency. In particular, the upper ohmic contact layer 102 serves as an interface for ohmic contact with the N-type electrode. Therefore, common dopants for the N-type indium gallium arsenide epitaxial layer include sulfur (S), selenium (Se), or silicon (Si), with a doping concentration typically ranging from 10¹⁸ to 10²⁰ cm⁻³. This concentration range helps reduce the Schottky barrier, achieving low-resistance ohmic contact.

Next, an epitaxial composite layer is grown on the upper ohmic contact layer 102, comprising a first compound semiconductor layer 103, a light-emitting layer 104, and a second compound semiconductor layer 105. The light-emitting layer 104 is formed by a multiple quantum well (MQW) structure made of indium gallium arsenide phosphide (InGaAsP) quaternary compound semiconductor and is sandwiched between the first compound semiconductor layer 103 and the second compound semiconductor layer 105. In this embodiment, the light-emitting wavelength band of the multiple quantum well may range from 1100 to 1700 nanometers (nm). Specifically, the first compound semiconductor layer 103 is an N-type indium phosphide (InP) epitaxial layer, and the second compound semiconductor layer 105 is a P-type zinc-doped indium phosphide (Zn-doped InP) epitaxial layer. It should be noted that the materials described in the above embodiment are merely exemplary, and the present invention is not limited thereto. In practical applications, the light-emitting layer may be a multiple quantum well (MQW) or double heterojunction (DH) structure, and the materials and their compositions may be adjusted based on the emission wavelength, such as aluminum gallium arsenide (AlGaAs), indium gallium arsenide (InGaAs), indium gallium phosphide (InGaP), aluminum gallium phosphide (AlGaP), aluminum gallium indium phosphide (AlGaInP), indium arsenide antimonide (InAsSb), indium aluminum antimonide (InAlSb), or indium arsenide antimonide phosphide (InAsSbP).

As shown in FIG. 1A, a compound semiconductor layer is further epitaxially grown on the epitaxial composite layer. In a specific embodiment, this compound semiconductor layer is a highly doped compound semiconductor layer 106, such as, but not limited to, a zinc-doped indium gallium arsenide phosphide (Zn-doped InGaAsP) epitaxial layer, with a preferred thickness of 500 to 5000 angstroms (Å). In particular, the doping concentration of this zinc-doped indium gallium arsenide phosphide epitaxial layer ranges from 10¹⁸ to 10²⁰ cm⁻³, which helps reduce contact resistance to form an ohmic contact with the subsequent metal layer interface. Next, on the surface of the highly doped compound semiconductor layer 106, a patterning process is performed based on the design requirements for the vertical current distribution of the light-emitting diode, and a metal stack 107 is deposited by evaporation or sputtering to form a plurality of conductive plugs on the surface of the highly doped compound semiconductor layer 106. This metal stack 107 may specifically be, for example, a titanium (Ti)/platinum (Pt)/gold (Au) stack, a titanium (Ti)/gold (Au) stack, or a composite stack of other metal materials, with a thickness of 2000 to 5000 angstroms (Å). Subsequently, a heating fusion alloy process is performed to integrate the metal stack 107 into the highly doped compound semiconductor layer 106.

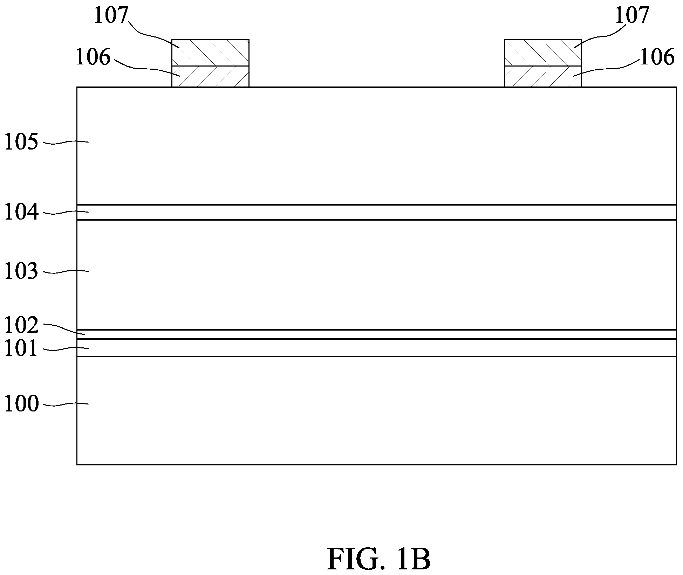

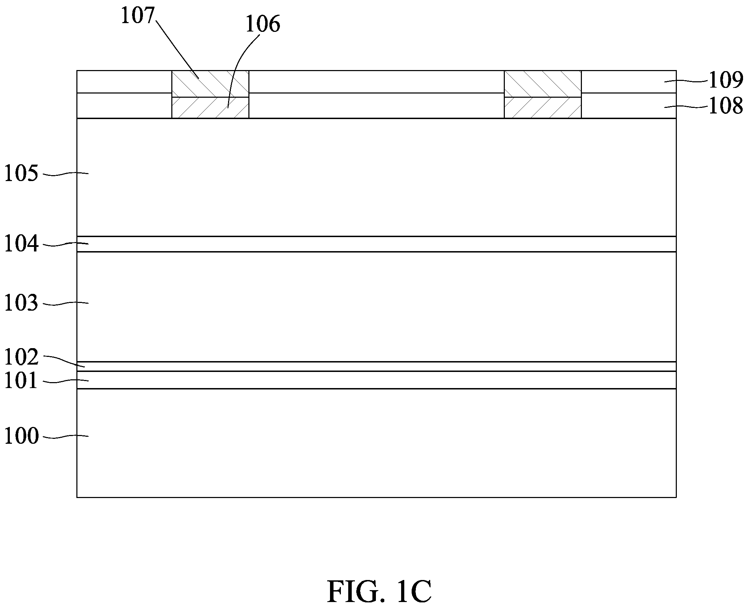

Please refer to FIG. 1B, where an etching process is performed on the highly doped compound semiconductor layer 106 to form a plurality of conductive plugs on the surface of the second compound semiconductor layer 105. The patterned highly doped compound semiconductor layer 106 and the metal stack 107 have the same pattern structure and distribution area, forming a plurality of dot-shaped conductive plugs in the light-emitting diode, which guide the vertical current between the upper and lower electrodes of the light-emitting diode chip to be uniformly distributed within the epitaxial structure, reducing current crowding. Next, as shown in FIG. 1C, a dielectric layer 108 is deposited to cover the entire wafer surface, followed by a photolithography etching process to remove a portion of the dielectric layer 108 until the metal stacks 107 in the dot-shaped conductive plugs are exposed. Specifically, the dielectric layer 108 is a dielectric layer, with materials such as silicon dioxide (SiO₂), silicon nitride (Si₃N₄), or silicon oxynitride (SiON). Then, a transparent conductive layer 109 is formed by evaporation or sputtering on the wafer surface to cover the exposed metal stacks 107 and the dielectric layer 108, electrically connecting to the metal stacks 107 of the conductive plugs. The transparent conductive layer 109 is made of materials such as indium tin oxide (ITO), aluminum-doped zinc oxide (AZO), indium zinc oxide (IZO), nickel oxide, cadmium tin oxide, antimony tin oxide, and combinations thereof.

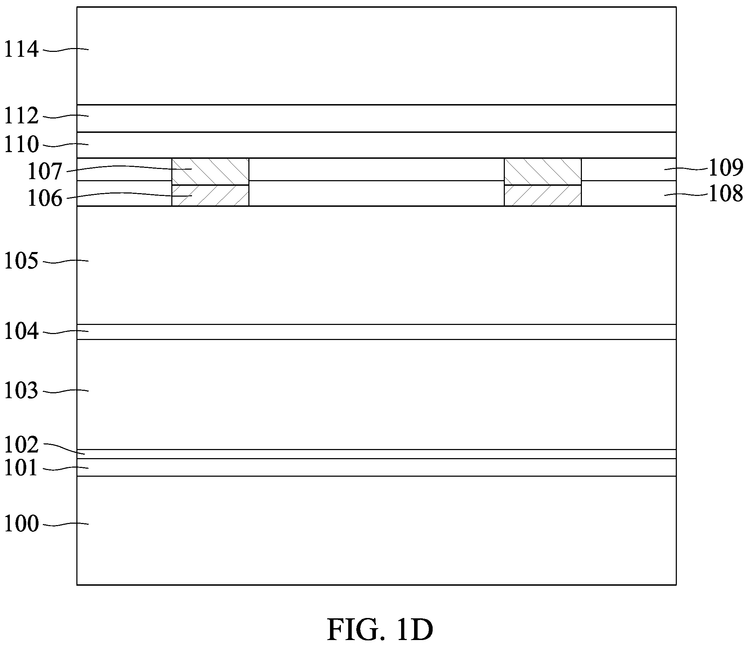

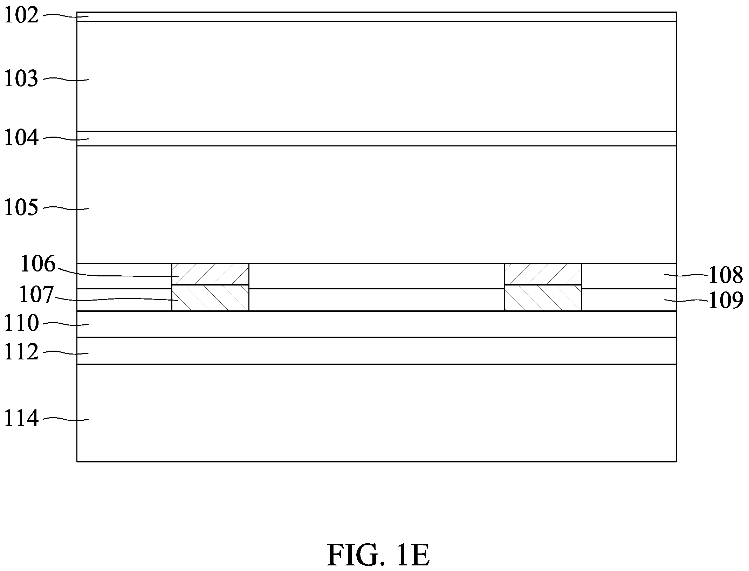

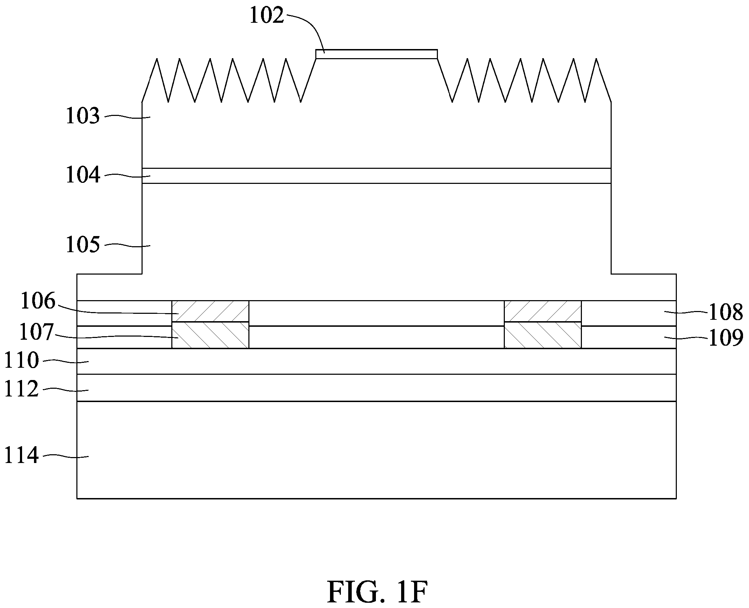

Please refer to FIG. 1D, where a reflective metal layer 110 is formed on the transparent conductive layer 109 by evaporation, followed by metal bonding with a reflective metal layer 112 on another permanent substrate 114. The transparent conductive layer 109 and the reflective metal layer 110 serve as a mirror system in the reflective layer of the light-emitting diode structure of this invention, reflecting the light emitted by the light-emitting layer upward to increase light extraction efficiency. The material of the reflective metal layer is selected from the group consisting of silver (Ag), titanium (Ti), platinum (Pt), gold (Au), indium (In), and combinations thereof. The permanent substrate 114 may be, but is not limited to, a silicon substrate. Next, as shown in FIG. 1E, the epitaxial growth substrate 100 and the buffer layer 101 (i.e., the N-type indium phosphide epitaxial layer) are removed from the opposite side of the permanent substrate 114 to expose the upper ohmic contact layer 102, and the structure is flipped so that the permanent substrate 114 is positioned at the bottom of the light-emitting diode structure. Subsequently, as shown in FIG. 1F, a planar region for the subsequent formation of the upper electrode is defined on the first compound semiconductor layer 103, and other regions of the first compound semiconductor layer 103 are subjected to roughening treatment. Then, a mesa etching process is performed to etch a portion of the epitaxial composite layer, i.e., a portion of the first compound semiconductor layer 103, the light-emitting layer 104, and the second compound semiconductor layer 105, to expose the roughened surface of the first compound semiconductor layer 103.

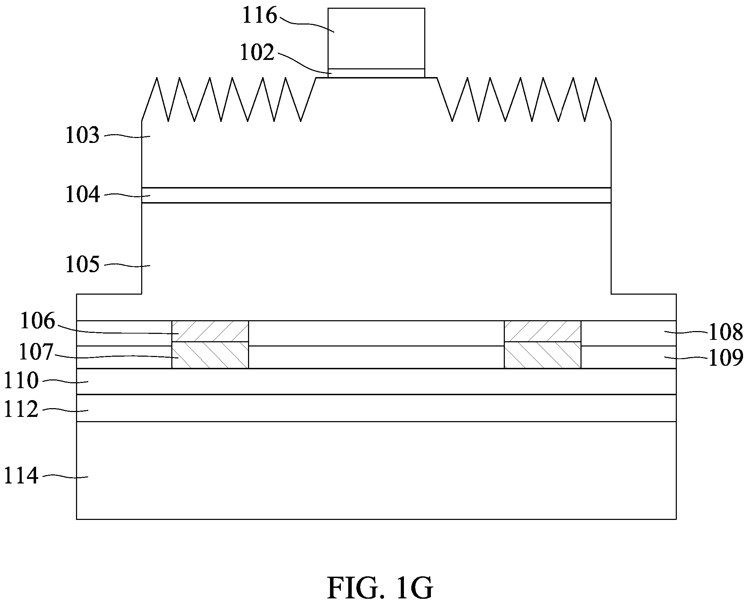

Please refer to FIG. 1G, where a patterning process and metal deposition for the upper electrode are performed, and through a high-temperature fusion process, an ohmic contact is formed between the metal film of the upper electrode and the upper ohmic contact layer 102. Then, the upper ohmic contact layer 102 is etched to form a patterned upper electrode 116 and a patterned upper ohmic contact layer 102. The material of the upper electrode 116 may be germanium gold (GeAu), germanium gold nickel (GeAuNi), germanium titanium platinum gold (GeTiPtAu), or combinations thereof. In particular, the patterned upper electrode 116 and the patterned upper ohmic contact layer 102 have the same cross-sectional horizontal width by removing portions of the upper ohmic contact layer 102 that do not overlap with the upper electrode 116, thereby reducing the light absorption area of the upper ohmic contact layer 102 and enhancing emission efficiency. Moreover, the patterned upper electrode 116, the patterned upper ohmic contact layer 102, and the plurality of lower dot-shaped conductive plugs do not overlap in vertical position, further ensuring that the vertical current between the upper and lower electrodes of the light-emitting diode chip is uniformly distributed within the crystal structure, reducing current concentration.

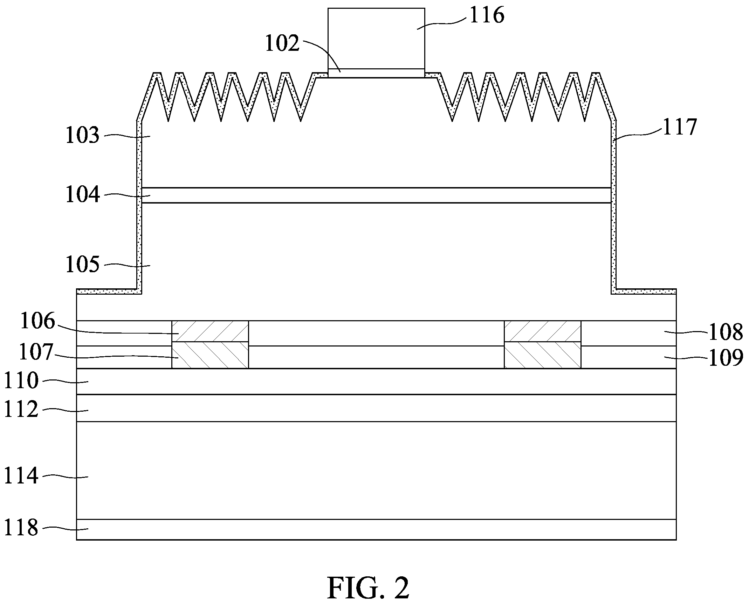

Please continue to refer to FIG. 2, where a protective layer deposition process is subsequently performed to form a protective layer 117 covering the first compound semiconductor layer 103 and the upper electrode 116. The material of the protective layer 117 may be silicon dioxide (SiO₂), silicon nitride (Si₃N₄), silicon oxynitride (SiON), or the like. Subsequently, a photolithography etching process is used to remove a portion of the protective layer 117 covering the surface of the upper electrode 116, exposing the surface of the upper electrode 116. Finally, the backside of the permanent substrate 114 is ground and polished, followed by P-type metal deposition and fusion processes to form a lower electrode 118, completing the basic structure of the light-emitting diode in one embodiment of this invention. As shown in FIG. 2, a key feature of the light-emitting diode in this embodiment of the invention is that, compared to traditional light-emitting diode structures, the area of the upper and lower ohmic contact layers in the light-emitting diode structure of this invention is significantly reduced. Specifically, the areas of the upper ohmic contact layer 102 and the highly doped compound semiconductor layer 106 have been correspondingly patterned and reduced based on the area of the metal electrodes forming ohmic contacts, removing portions not in ohmic contact with the metal electrodes. Since ohmic contact layers are typically highly doped to achieve low-resistance ohmic contact, they have the drawback of absorbing light emitted by the light-emitting layer. Therefore, one technical feature of this invention is to maintain only the necessary ohmic contact area between the ohmic contact layer and the electrode structure, removing the remaining portions not required for ohmic contact, substantially reducing the impact of the ohmic contact layer on emission and enhancing emission efficiency. In one embodiment, taking the highly doped compound semiconductor layer 106 as an example, the total lateral distribution area of the patterned lower ohmic contact layer is the same as the lateral distribution area of the dot-shaped conductive plugs, accounting for only 2.8% to 5.2% of the total lateral area of the epitaxial composite layer after the mesa process, significantly improving the emission efficiency of the light-emitting diode. Additionally, the materials of the upper and lower ohmic contact layers mentioned above are for illustrative purposes only. In practical applications of this invention, appropriate adjustments can be made based on different device specifications. For example, ohmic contact materials may also include indium gallium phosphide (InGaP), aluminum gallium arsenide (AlGaAs), aluminum gallium phosphide (AlGaP), aluminum gallium indium phosphide (AlGaInP), indium arsenide antimonide (InAsSb), indium aluminum antimonide (InAlSb), or indium arsenide antimonide phosphide (InAsSbP).

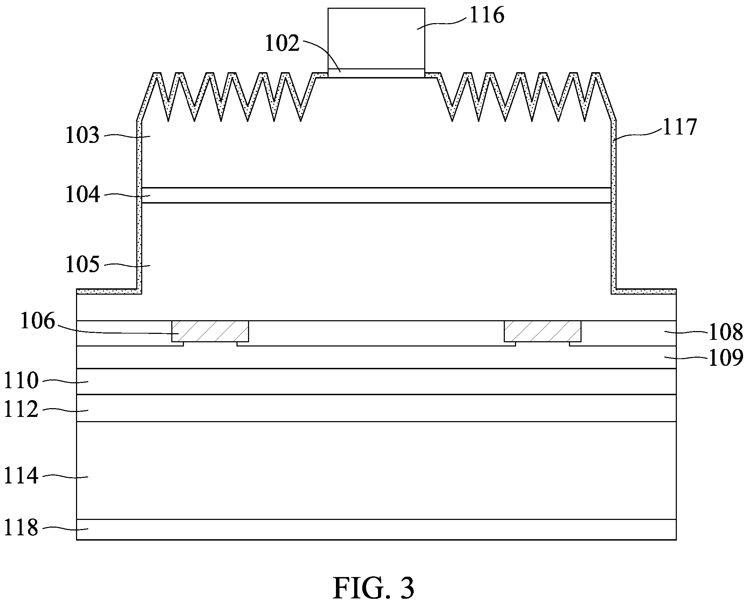

Please refer to FIG. 3, which illustrates a light-emitting diode in another embodiment of this invention. Unlike the previous disclosure, in this embodiment, the conductive plugs of the light-emitting diode form an ohmic contact directly between a transparent conductive material (e.g., indium tin oxide (ITO), aluminum-doped zinc oxide (AZO), indium zinc oxide (IZO), etc.) and the highly doped compound semiconductor layer 106. Specifically, as shown in FIG. 1A, after the highly doped compound semiconductor layer 106 is epitaxially formed, no metal deposition process for the metal stack 107 is performed. Instead, a patterning etching process is directly performed on the highly doped compound semiconductor layer 106, followed sequentially by a dielectric layer 108 deposition process and a transparent conductive layer 109 deposition process, allowing the transparent conductive material to fill the conductive plugs and form an ohmic contact with the highly doped compound semiconductor layer 106. Similarly, the area of the upper and lower ohmic contact layers in this embodiment is significantly reduced compared to traditional light-emitting diodes, enhancing the emission efficiency of the light-emitting diode in this embodiment.

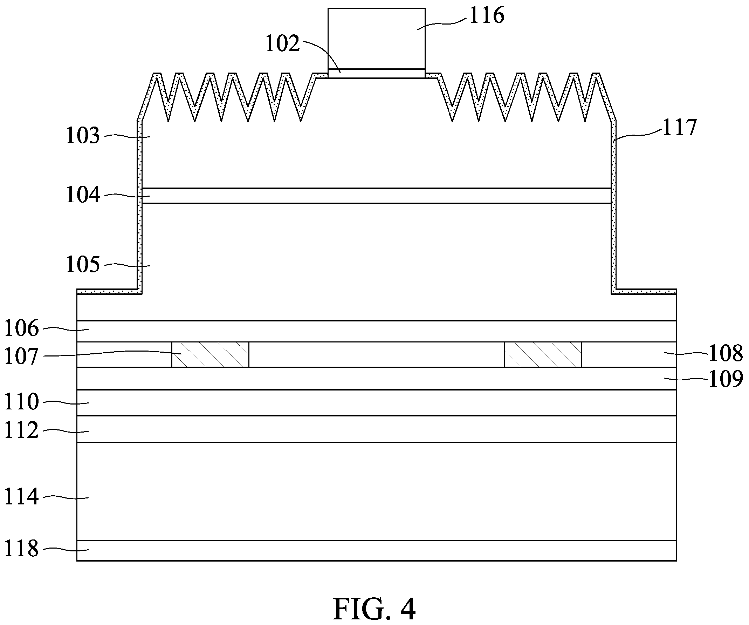

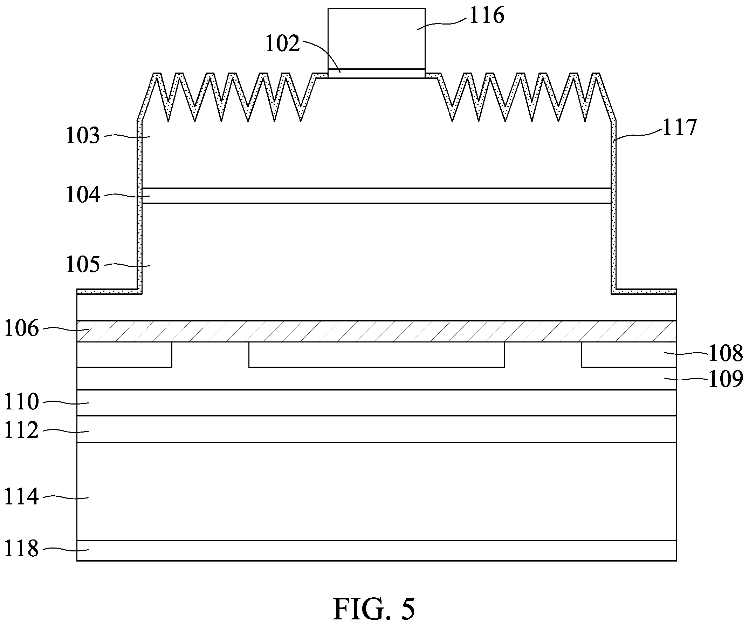

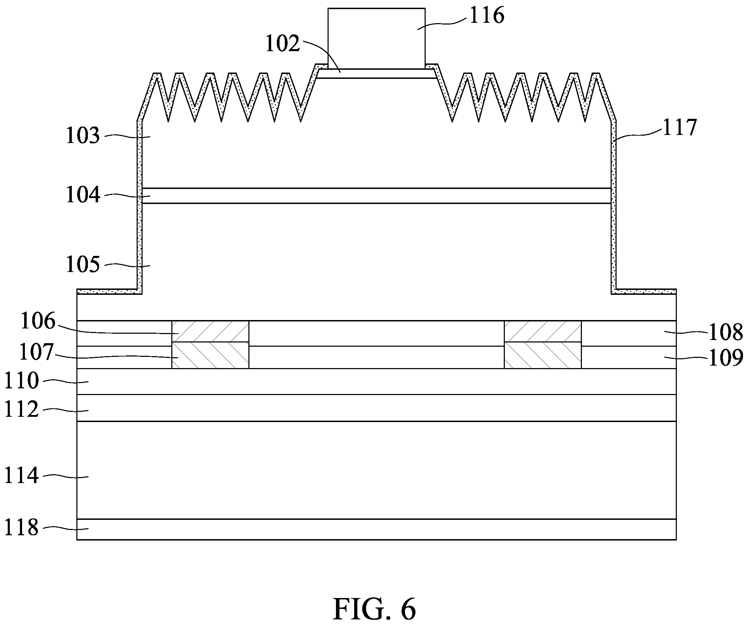

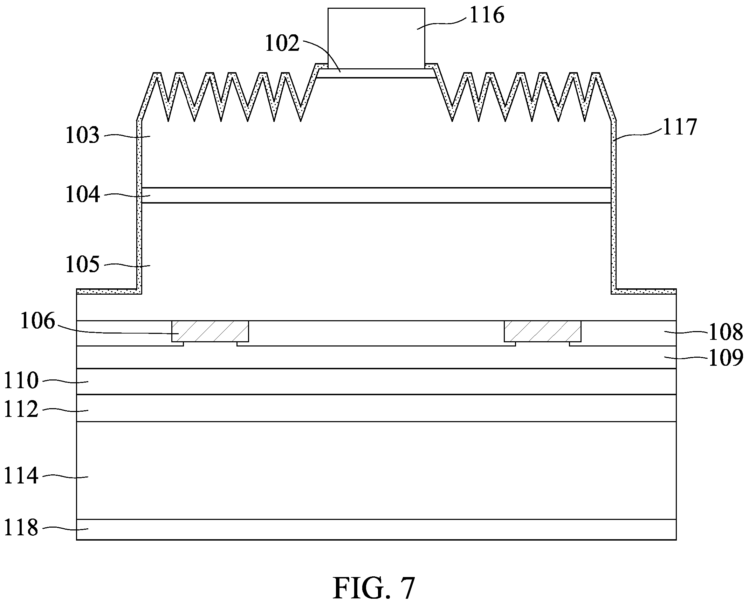

The light-emitting diodes shown in FIG. 2 and FIG. 3 are preferred embodiments of this invention, and those skilled in the art may make appropriate modifications after understanding this invention. For example, as shown in FIG. 4 and FIG. 5, the technical means of patterning the ohmic contact layer is applied to the upper ohmic contact layer 102, which has the same cross-sectional horizontal width as the upper electrode 116. In contrast, in the lower ohmic contact layer, the highly doped compound semiconductor layer 106 remains as a full layer structure without patterning. Specifically, FIG. 4 shows the highly doped compound semiconductor layer 106 forming an ohmic contact with the metal stack 107 in the conductive plugs, while FIG. 5 shows the highly doped compound semiconductor layer 106 forming an ohmic contact with the transparent conductive layer 109 in the conductive plugs. Similarly, as shown in FIG. 6 and FIG. 7, the technical means of patterning the ohmic contact layer is applied to the lower ohmic contact layer, patterning the highly doped compound semiconductor layer 106, while maintaining the full layer structure of the upper ohmic contact layer 102, which does not have the same cross-sectional horizontal width as the upper electrode 116. Specifically, FIG. 6 shows the patterned highly doped compound semiconductor layer 106 forming an ohmic contact with the metal stack 107 in the conductive plugs, while FIG. 7 shows the patterned highly doped compound semiconductor layer 106 forming an ohmic contact with the transparent conductive layer 109 in the conductive plugs.

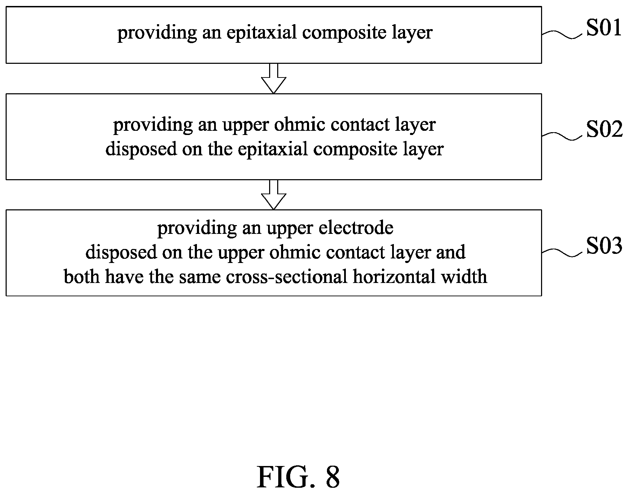

Please refer to FIG. 8, which illustrates a schematic flowchart of the manufacturing process of the light-emitting diode of this invention. First, in step S01, an epitaxial composite layer is provided, having a light-emitting layer with a light-emitting wavelength band of 1100 to 1700 nanometers (nm). In step S02, an upper ohmic contact layer is provided, disposed on the epitaxial composite layer. Next, in step S03, an upper electrode is provided, disposed on the upper ohmic contact layer and electrically connected to the epitaxial composite layer. The upper ohmic contact layer forms an ohmic contact with the upper electrode, and both have the same cross-sectional horizontal width. The details of the components in the aforementioned process steps are described above and will not be repeated here.

The above embodiments are provided to illustrate the implementations of the present invention and to explain its technical features, and are not intended to limit the scope of the present invention. Any modifications or equivalent arrangements that can be easily accomplished by those skilled in the art fall within the scope of the present invention, and the scope of the present invention should be defined by the claims.

## Claims

1. A light-emitting diode, comprising:
a permanent substrate;
an epitaxial composite layer having a light-emitting layer with a light-emitting wavelength band of 1100 to 1700 nanometers (nm), disposed on the permanent substrate;
an upper electrode disposed on the epitaxial composite layer, electrically connected to the epitaxial composite layer; and
an upper ohmic contact layer sandwiched between the upper electrode and the epitaxial composite layer,
wherein an ohmic contact is formed between the upper ohmic contact layer and the upper electrode, and both of the upper ohmic contact layer and the upper electrode have the same cross-sectional horizontal width.

2. The light-emitting diode of the previous claim, wherein the upper ohmic contact layer is an indium gallium arsenide (InGaAs) layer.

3. The light-emitting diode of any of the two previous claims, further comprising a reflective metal layer disposed on the permanent substrate.

4. The light-emitting diode of the previous claim, further comprising a transparent conductive layer sandwiched between the reflective metal layer and the epitaxial composite layer, having a plurality of conductive plugs disposed in the transparent conductive layer, wherein each of the conductive plugs includes a highly doped compound semiconductor layer lattice-matched and electrically connected to the epitaxial composite layer, forming an ohmic contact with the transparent conductive layer.

5. The light-emitting diode of the previous claim, wherein the highly doped compound semiconductor layer is a zinc-doped indium gallium arsenide phosphide (Zn-doped InGaAsP) layer

6. The light-emitting diode of any of the two previous claims, wherein each conductive plug further comprises a metal stack sandwiched between the transparent conductive layer and the highly doped compound semiconductor layer, wherein the metal stack is a titanium (Ti)/platinum (Pt)/gold (Au) stack.

7. The light-emitting diode of claim 3, wherein the material of the reflective metal layer is selected from the group consisting of silver (Ag), titanium (Ti), platinum (Pt), gold (Au), indium (In), and combinations thereof.

8. The light-emitting diode of claim 4, wherein the upper electrode and the conductive plugs do not overlap in vertical position.

9. A light-emitting diode, comprising:
a permanent substrate;
a reflective metal layer disposed on the permanent substrate;
an epitaxial composite layer having a light-emitting layer with a light-emitting wavelength band of 1100 to 1700 nanometers (nm), disposed on the reflective metal layer; and
a transparent conductive layer sandwiched between the reflective metal layer and the epitaxial composite layer, having a plurality of conductive plugs disposed in the transparent conductive layer, wherein each conductive plug includes a highly doped compound semiconductor layer that is lattice-matched and electrically connected to the epitaxial composite layer, forming an ohmic contact with the transparent conductive layer.

10. The light-emitting diode of the previous claim, wherein
the highly doped compound semiconductor layer is a zinc-doped indium gallium arsenide phosphide (Zn-doped InGaAsP) layer, and/or wherein
each conductive plug further comprises a metal stack sandwiched between the transparent conductive layer and the highly doped compound semiconductor layer, wherein the metal stack is a titanium (Ti)/platinum (Pt)/gold (Au) stack, and/or wherein
the material of the reflective metal layer is selected from the group consisting of silver (Ag), titanium (Ti), platinum (Pt), gold (Au), indium (In), and combinations thereof.

11. A manufacturing method of a light-emitting diode, comprising:
providing an epitaxial composite layer having a light-emitting layer with a light-emitting wavelength band of 1100 to 1700 nanometers (nm);
providing an upper ohmic contact layer disposed on the epitaxial composite layer; and
providing an upper electrode disposed on the upper ohmic contact layer and electrically connected to the epitaxial composite layer, wherein
the upper ohmic contact layer forms an ohmic contact with the upper electrode, and both have the same cross-sectional horizontal width.

12. The manufacturing method of the previous claim, wherein the step of providing an upper ohmic contact layer is a step of providing an indium gallium arsenide (InGaAs) layer.

13. The manufacturing method of any of the two previous claims, further comprising providing a reflective metal layer disposed on a permanent substrate.

14. The manufacturing method of the previous claim, further comprising providing a transparent conductive layer sandwiched between the reflective metal layer and the epitaxial composite layer, the transparent conductive layer having a plurality of conductive plugs disposed in the transparent conductive layer, wherein each conductive plug includes a highly doped compound semiconductor layer lattice-matched and electrically connected to the epitaxial composite layer, forming an ohmic contact with the transparent conductive layer.

15. The manufacturing method of the previous claim, wherein the highly doped compound semiconductor layer is a zinc-doped indium gallium arsenide phosphide (Zn-doped InGaAsP) layer, and/or wherein each conductive plug further comprises a metal stack sandwiched between the transparent conductive layer and the highly doped compound semiconductor layer, wherein the metal stack is a titanium (Ti)/platinum (Pt)/gold (Au) stack.
